(19) Europäisches Patentamt / European Patent Office / Office européen des brevets

(11) **EP 4 534 484 A1**

(12) **EUROPEAN PATENT APPLICATION**
published in accordance with Art. 153(4) EPC

(43) Date of publication:
09.04.2025 Bulletin 2025/15

(21) Application number: 23815919.8

(22) Date of filing: 25.05.2023

(51) International Patent Classification (IPC):
$C01G\ 37/00^{(2006.01)}$  $C08L\ 101/00^{(2006.01)}$
$C08K\ 3/013^{(2018.01)}$  $C08K\ 3/24^{(2006.01)}$
$H05K\ 3/10^{(2006.01)}$

(52) Cooperative Patent Classification (CPC):
C01G 37/00; C08K 3/013; C08K 3/24;
C08L 101/00; H05K 3/10

(86) International application number:
PCT/JP2023/019459

(87) International publication number:
WO 2023/234161 (07.12.2023 Gazette 2023/49)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 02.06.2022 JP 2022090174

(71) Applicant: DIC Corporation
Tokyo 174-8520 (JP)

(72) Inventors:
• TABUCHI, Minoru
Sakura-shi
Chiba 285-8668 (JP)

• SEKINE, Ryosuke
Sakura-shi
Chiba 285-8668 (JP)
• YAGI, Naoto
Sakura-shi
Chiba 285-8668 (JP)
• OMICHI, Koji
Sakura-shi
Chiba 285-8668 (JP)
• YUAN, Jianjun
Sakura-shi
Chiba 285-8668 (JP)

(74) Representative: TBK
Bavariaring 4-6
80336 München (DE)

(54) **COPPER-CHROMIUM OXIDE SPINEL, AND RESIN COMPOSITION AND RESIN MOLDED ARTICLE THEREOF**

(57) An object is to provide a copper-chromium oxide spinel having excellent dispersibility in a resin composition and excellent adhesion to plating, and a resin composition and a resin molded article containing the copper-chromium oxide spinel. Specifically, provided is a copper-chromium oxide spinel with a particle size distribution spread SPAN = (D90 - D10)/D50 of 2 or less where, in volume-converted particle size distribution obtained by a laser diffraction and scattering method, particle sizes with a cumulative frequency from a smaller particle size side of 10%, 50%, and 90% are D10, D50, and D90, respectively.

[FIG. 1]

**Description**

Technical Field

The present invention relates to a copper-chromium oxide spinel with controlled particle size distribution, and a resin composition and a molded article containing the copper-chromium oxide spinel.

Background Art

In recent years, in the fields of electronics and mechatronics, devices have become smaller, lighter, and more multifunctional. In the automotive field in particular, while sensors and modules are increasing due to the progress of connectivity, servicing, and automation, there is a demand to reduce vehicle weight for electrification and there is a strong demand to reduce the weight and size of mechanical components and electric circuit components. As techniques that can address this issue, techniques related to molded interconnect devices (MIDs) are attracting attention. MID is a technique for molding circuits, electrodes, and the like into a resin molded article, and by integrating circuits, electrodes, and the like into the resin molded article, it is possible to reduce the size and weight of components.

MID includes the one-time molding method in which the surface of the resin molded article is roughened and plated, the two-time molding method in which a resin for forming circuits and a resin for forming insulating parts are separately molded twice and then integrated, and the hot stamping method in which circuits and the like are formed directly on the resin molded article using a stamping die.

Among these, the laser direct structuring (LDS) technique, a type of the one-time molding method, has attracted particular attention from the viewpoint of being able to reduce manufacturing costs and being able to produce ultrafine circuits in a short period of time, for example. Note that the LDS technique is a technique in which when a laser is applied to a resin molded article containing a certain additive, and the surface of the part to which the laser has been applied is roughened and the additive is activated, thus enabling formation of a strong plated layer in the part to which the laser has been applied.

Given these circumstances, the additive that can be used for the LDS technique is being studied. For the additive, spinel type metal oxides are being commonly used (PTL 1 and PTL 2) In particular, spinel type metal oxides containing copper have been utilized from the viewpoint of adhesion to copper-plated patterns.

PTL 1 shows a conductor track structure containing a high oxide having high thermal stability and having a spinel structure having resistance in an acidic or alkaline aqueous metallization bath, or a simple d-metal oxide or a mixture thereof, or a mixed metal oxide similar to the spinel structure.

PTL 2 shows a thermosetting resin composition for LDS containing a non-conductive metal compound forming metallic nuclei by the application of active energy rays in which the non-conductive metal compound contains one or more selected from the group consisting of spinel type metal oxides, metal oxides having two or more transition metal elements in which they are selected from Group 3 to Group 12 of the periodic table and the groups are adjacent to each other, and tin-containing oxides.

PTL 3 discloses a thermoplastic composition with improved plating performance and shows that the composition contains a metallic compound in an amount of 1 wt% with respect to the weight of a crude composition and the metallic compound is represented by $AB_2O_4$.

However, PTL 1, PTL 2, and PTL 3 described above, for example, use commercially available metal oxides and do not sufficiently study metal oxides. For example, there is a problem in that if the particle size distribution is not controlled, a metal oxide is not uniformly dispersed in a resin, and the presence of coarse particles on the surface of a cured product leads to a rough surface, resulting in variations in the adhesion of plating and plating processing. Thus, there is a demand for a copper-chromium oxide spinel having certain particle size distribution and particle size, but knowledge about conventional copper-chromium oxide spinels and methods for producing the same is limited, and there is still room for further study.

Citation List

Patent Literature

PTL 1: Japanese Unexamined Patent Application Publication (Translation of PCT Application) No. 2004-534408
PTL 2: WO 2017/199639
PTL 3: Japanese Unexamined Patent Application Publication (Translation of PCT Application) No. 2015-501868

Summary of Invention

Technical Problem

Given these circumstances, the present invention has been made to solve the above problems and an object thereof is to provide a copper-chromium oxide spinel with controlled particle size distribution and a resin composition containing the copper-chromium oxide spinel. Solution to Problem

The inventors of the present invention have intensively studied to solve the above problems and found that by controlling the particle size distribution of a copper-chromium oxide spinel, the surface of a cured product of a resin composition to be obtained becomes smooth, and plating is uniformly formed and has excellent adhesion to complete the present invention.

That is, the present invention has the following aspects.

(1) A copper-chromium oxide spinel with a particle size distribution spread SPAN = (D90 - D10)/D50 of 2 or less where, in volume-converted particle size distribution obtained by a laser diffraction and scattering method, particle sizes with a cumulative frequency from a smaller particle size side of 10%, 50%, and 90% are defined as D10, D50, and D90, respectively.

(2) The copper-chromium oxide spinel according to (1) above, in which D50 is 5.0 μm or less.

(3) The copper-chromium oxide spinel according to (1) or (2) above, in which D90 is 10.0 μm or less.

(4) The copper-chromium oxide spinel according to any of (1) to (3) above, in which a shape of the copper-chromium oxide spinel is an octahedron.

(5) The copper-chromium oxide spinel according to (1) above, further containing molybdenum.

(6) A resin composition containing:

the copper-chromium oxide spinel according to any of (1) to (5) above;
a thermoplastic resin or a thermosetting resin; and
an inorganic filler.

(7) A resin molded article made by molding the resin composition according to (6) above.

Advantageous Effects of Invention

The present invention can provide a copper-chromium oxide spinel with controlled particle size distribution.

In addition, the present invention can provide a resin composition containing the copper-chromium oxide spinel having excellent plating adhesion and a molded article thereof.

Brief Description of Drawings

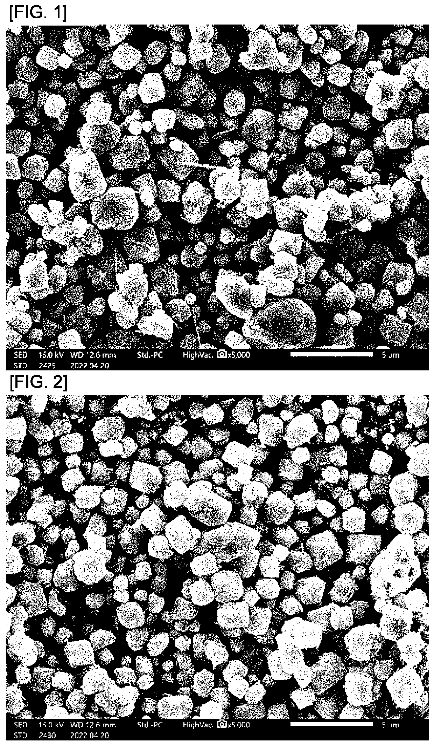

FIG. 1 is a SEM image of a copper-chromium oxide spinel of Example 1.
FIG. 2 is a SEM image of a copper-chromium oxide spinel of Example 2.

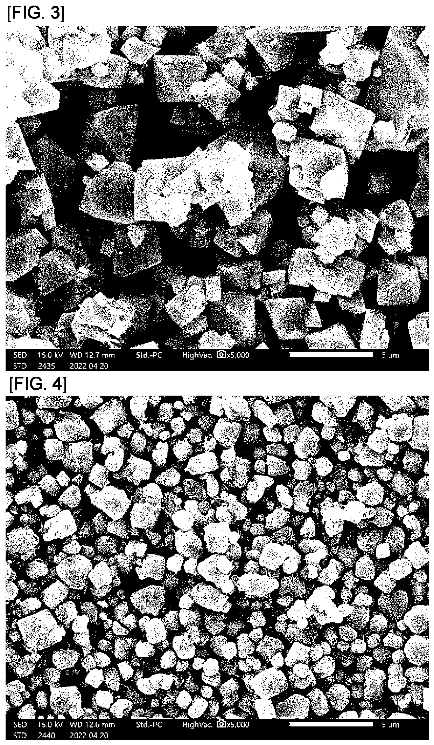

FIG. 3 is a SEM image of a copper-chromium oxide spinel of Example 3.
FIG. 4 is a SEM image of a copper-chromium oxide spinel of Example 4.

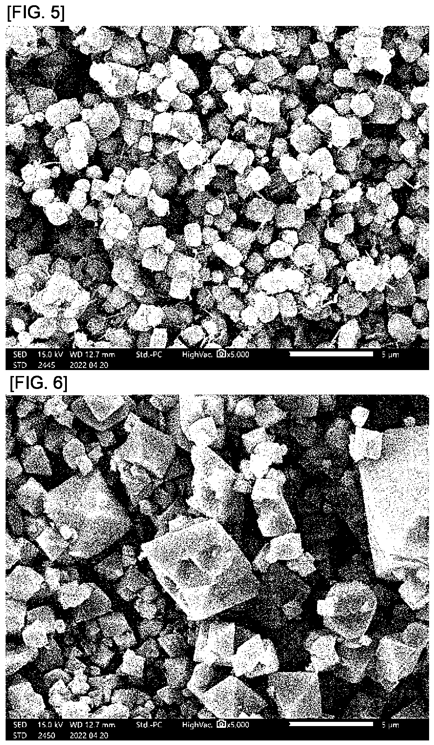

FIG. 5 is a SEM image of a copper-chromium oxide spinel of Example 5.
FIG. 6 is a SEM image of a copper-chromium oxide spinel of Example 6.

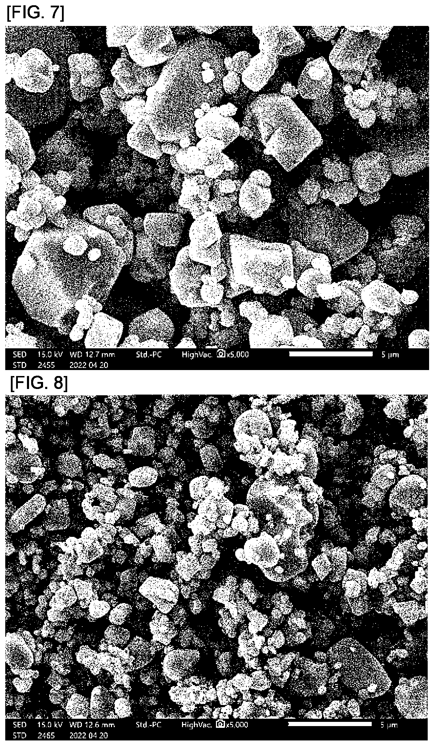

FIG. 7 is a SEM image of a copper-chromium oxide spinel of Comparative Example 1.
FIG. 8 is a SEM image of a copper-chromium oxide spinel of Comparative Example 2.

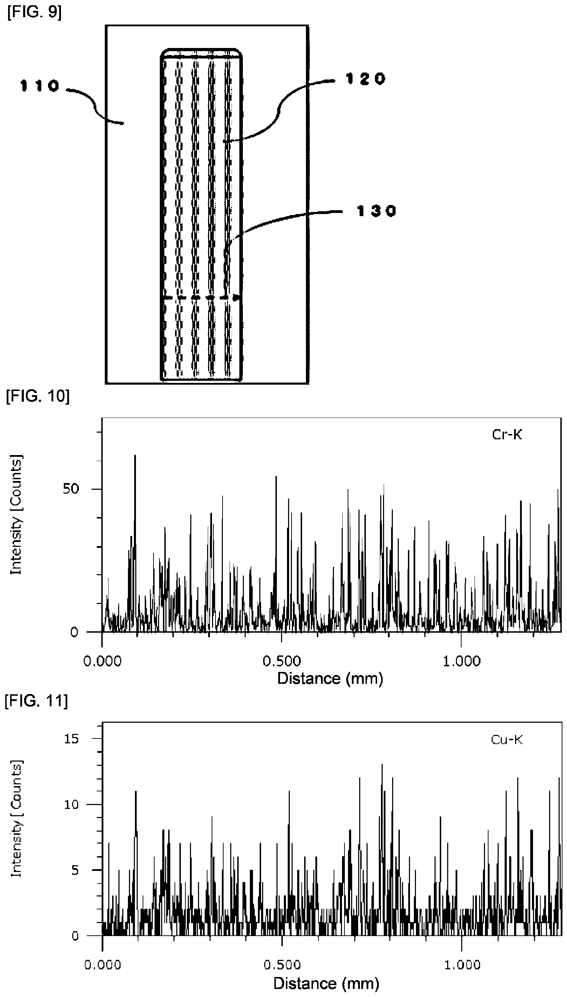

FIG. 9 is an evaluation image of metal elemental analysis.
FIG. 10 is a line profile of Cr in EDS line analysis of Example 1.
FIG. 11 is a line profile of Cu in the EDS line analysis of Example 1.

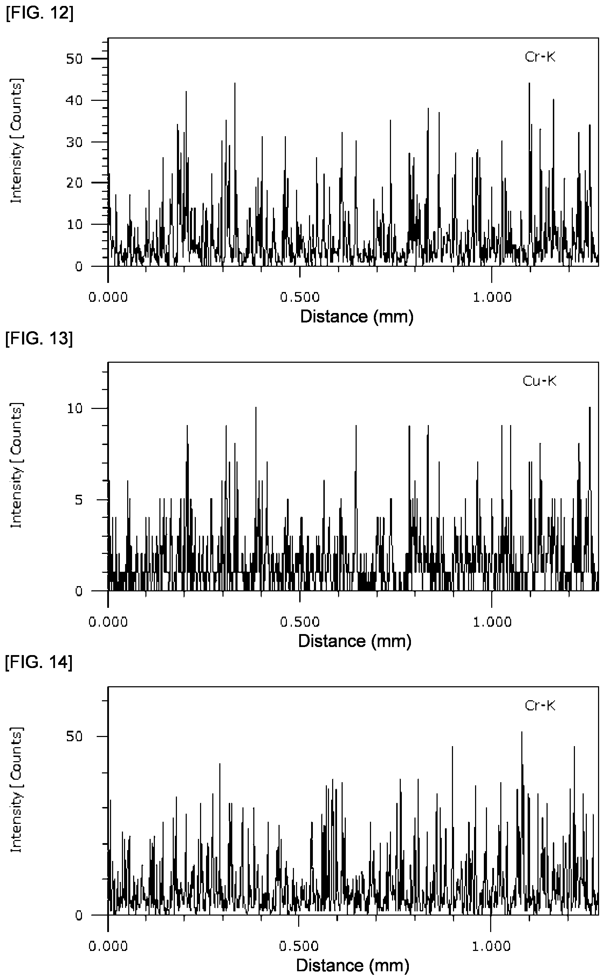

FIG. 12 is a line profile of Cr in EDS line analysis of Example 3.
FIG. 13 is a line profile of Cu in the EDS line analysis of Example 3.
FIG. 14 is a line profile of Cr in EDS line analysis of Example 4.

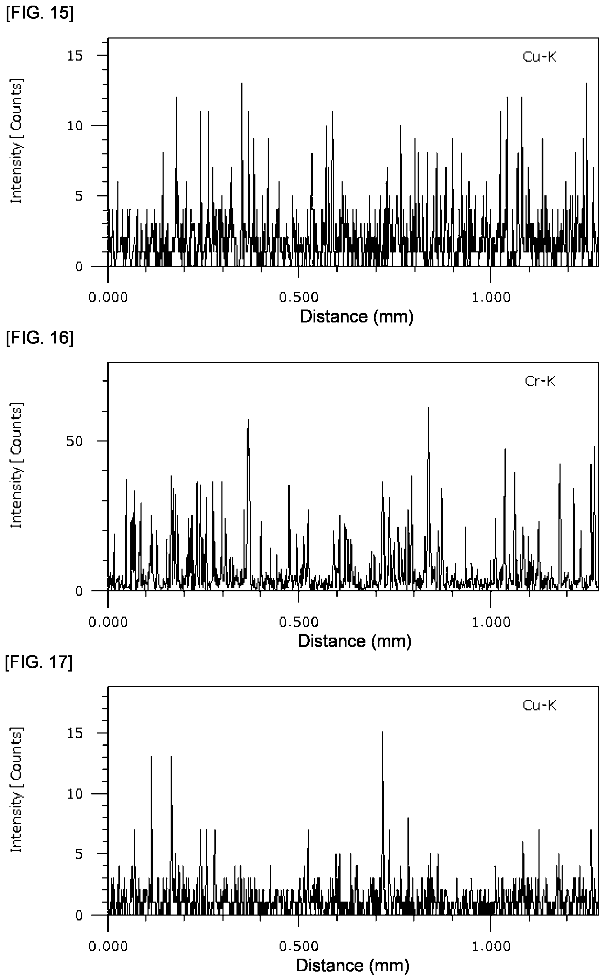

FIG. 15 is a line profile of Cu in the EDS line analysis of Example 4.
FIG. 16 is a line profile of Cr in EDS line analysis of Comparative Example 1.
FIG. 17 is a line profile of Cu in the EDS line analysis of Comparative Example 1.

Description of Embodiments

The following describes embodiments of a copper-chromium oxide spinel, a method for producing a copper-chromium oxide spinel, and a resin composition containing the particles of the present invention.

<Copper-Chromium Oxide Spinel>

The particle size distribution spread of the copper-chromium oxide spinel of the embodiment calculated by a laser diffraction and scattering method may be 2 or less, 1.9 or less, or 1.5 or less. Being within the above range provides excellent dispersibility in a resin and provides excellent plating adsorption performance when made into a molded article, which is preferred.

In the present specification, the particle size distribution spread calculated by the laser diffraction and scattering method is calculated using the following conversion equation.

Particle size distribution spread: $SPAN = (D90 - D10)/D50$

The D10, D50, and D90 particle sizes refer to particle sizes, in volume-converted particle size distribution obtained by the laser diffraction and scattering method, with a cumulative frequency from a smaller particle size side of 10%, 50%, and 90%, respectively.

The median diameter D50 of the copper-chromium oxide spinel of the embodiment calculated by the laser diffraction and scattering method is preferably 5.0 $\mu$m or less, more preferably 0.5 to 4.0 $\mu$m, and particularly preferably 1.0 to 3.0 $\mu$m. Being within the above range improves the plating adsorption performance when made into an LDS resin composition, which is preferred.

The median diameter D90 of the copper-chromium oxide spinel of the embodiment calculated by the laser diffraction and scattering method is preferably 10 $\mu$m or less, more preferably 1.0 to 9.0 $\mu$m, even more preferably 2.0 to 8.0 $\mu$m, and particularly preferably 2.5 to 4.0 $\mu$m. Being within the above range reduces unevenness on the surface of a molded product by coarse particles and improves the plating adsorption performance when made into the LDS resin composition, which is preferred.

In the present specification, controlling a particle shape means that the particle shape is not amorphous. That is, in the present specification, the copper-chromium oxide spinel with a controlled particle shape means the copper-chromium oxide spinel the particle shape of which is not amorphous.

The copper-chromium oxide spinel of the embodiment may have a polygonal shape. In particular, it is preferably rectangular parallelepipedal, cubic, polyhedral, triangular pyramidal, or rectangular pyramidal, more preferably rectangular parallelepipedal, cubic, or polyhedral, even more preferably polyhedral, and particularly preferably octahedral. Being the above shape provides highly crystallinity having a single crystal structure, which is preferred. The copper-chromium oxide spinel of the embodiment has a controlled crystal shape and can have polygonal automorphism. The copper-chromium oxide spinel with a controlled crystal shape can be produced by, for example, a method for producing a copper-chromium oxide spinel of the embodiment described below.

When the copper-chromium oxide spinel having an octahedral shape is contained, it is preferred that 50% or more of the particles have the octahedral shape, it is more preferred that 80% or more of the particles have the octahedral shape, and it is even more preferred that 90% or more of the particles have the octahedral shape on a mass basis or number basis.

Whether a material is highly crystalline can be determined by measurement using SmartLab (manufactured by Rigaku Corporation), an X-ray diffraction apparatus, using a high-intensity, high-resolution crystal analyzer (CALSA) as a detector, and using PDXL as analysis software. For the method of measurement, the 2$\theta$/$\theta$ method is used, and for analysis, a method of calculation using the Scherrer equation based on the full width at half maximum (FWHM) of a peak can be used.

The copper-chromium oxide spinel of the present invention may further contain molybdenum, sodium, and/or potassium.

When molybdenum is contained, a molybdenum content contained in the copper-chromium oxide spinel can be measured by XRF analysis. It is preferably 0.03% by mass or more, more preferably 0.03 to 5.0% by mass, and even more preferably 0.1 to 2.5% by mass in terms of a content ($Mo_1$), which is determined by performing the XRF analysis on the copper-chromium oxide spinel of the embodiment.

For the XRF analysis, an X-ray fluorescence analyzer (for example, Primus IV manufactured by Rigaku Corporation) can be used.

The content ($Mo_1$) in terms of $MoO_3$ conversion refers to a value determined from a $MoO_3$ amount obtained by converting the molybdenum content determined by performing the XRF analysis on the copper-chromium oxide spinel using a calibration curve for $MoO_3$ conversion. Note that the content ($Mo_1$) is relative to 100% by mass of the copper-chromium oxide spinel.

A molybdenum content contained in a surface layer of the copper-chromium oxide spinel can be measured by X-ray photoelectron spectroscopy (XPS) surface analysis. The molybdenum content in the surface layer of the copper-chromium oxide spinel of the embodiment is preferably 0.03% by mass or more, preferably 0.03 to 15.0% by mass, more preferably 0.5 to 10.0% by mass, and even more preferably 0.5 to 7.0% by mass in terms of a content ($Mo_2$), which is determined by performing the XPS surface analysis on the copper-chromium oxide spinel. Being within the above range more activates copper of the copper-chromium oxide spinel exposed by laser application and makes it easy for plating to bond, which is preferred.

For the XPS analysis, a scanning X-ray photoelectron spectrometer (for example, QUANTERA SXM manufactured by ULVAC-PHI, Inc.) can be used.

The content ($Mo_2$) refers to a value determined as the content of $MoO_3$ with respect to 100% by mass of the surface layer of the copper-chromium oxide spinel by performing the XPS surface analysis on the copper-chromium oxide spinel to acquire a presence ratio (atom%) for each element and performing oxide conversion on the molybdenum content.

The molybdenum is preferably unevenly present in the surface layer of the copper-chromium oxide spinel.

In the present specification, the "surface layer" refers to being within 10 nm of the surface of the copper-chromium oxide spinel of the embodiment. This distance corresponds to XPS detection depth used for measurement in examples.

The "unevenly present in the surface layer" refers to a state in which the mass of molybdenum or a molybdenum compound per unit volume in the surface layer is larger than the mass of molybdenum or a molybdenum compound per unit volume in other than the surface layer.

In the copper-chromium oxide spinel, molybdenum being unevenly present in the surface layer of the copper-chromium oxide spinel can be determined by the fact that the content of molybdenum ($Mo_2$) in terms of $MoO_3$ conversion with respect to 100% by mass of the surface layer of the copper-chromium oxide spinel, which is determined by performing the XPS surface analysis on the copper-chromium oxide spinel, is larger than the content of molybdenum ($Mo_1$) in terms of $MoO_3$ conversion with respect to 100% by mass of the copper-chromium oxide spinel, which is determined by performing the X-ray fluorescence (XRF) analysis on the copper-chromium oxide spinel.

In the copper-chromium oxide spinel, as an indicator for molybdenum to be unevenly present in the surface layer of the copper-chromium oxide spinel, the copper-chromium oxide spinel of the embodiment has a molybdenum surface layer uneven presence ratio ($Mo_2/Mo_1$), which is the content ($Mo_2$) determined by the XPS surface analysis with respect to the content ($Mo_1$) determined by the XRF analysis, of preferably 1.0 or more, and more preferably 2.0 or more and preferably 300 or less, more preferably 50 or less, and even more preferably 30 or less.

When molybdenum or a molybdenum compound is contained, not only the copper-chromium oxide spinel having desired particle size distribution can easily be obtained but also molybdenum-derived characteristics can be obtained. In particular, by making molybdenum or a molybdenum compound unevenly present in the surface layer of the copper-chromium oxide spinel, excellent characteristics such as catalytic activity can be imparted more efficiently than when molybdenum or a molybdenum compound is made uniformly present not only in the surface layer but also other than the surface layer (an inner layer).

When molybdenum is contained, a copper content contained in the copper-chromium oxide spinel is preferably 25.0% by mass or more, more preferably 30.0 to 40.0% by mass, and even more preferably 32.0 to 35.0% by mass in terms of a content ($Cu_1$), which is determined by performing the XRF analysis.

The content ($Cu_1$) in terms of CuO conversion refers to a value determined from a CuO amount by converting the copper content determined by performing the XRF analysis on the copper-chromium oxide spinel using a calibration curve for CuO conversion. Note that the content ($Cu_1$) is relative to 100% by mass of the copper-chromium oxide spinel.

A copper content contained in the surface layer of the copper-chromium oxide spinel can be measured by the XPS surface analysis. The copper content in the surface layer of the copper-chromium oxide spinel is preferably 50.0% by mass or more, more preferably 50.0 to 80.0% by mass, and even more preferably 60.0 to 75.0% by mass in terms of a content ($Cu_2$), which is determined by performing the XPS surface analysis on the copper-chromium oxide spinel. Being within the above range makes copper of the copper-chromium oxide spinel activated by laser application present in a large amount and makes it easy for plating to bond, which is preferred.

The content ($Cu_2$) refers to a value determined as the content of CuO with respect to 100% by mass of the surface layer of the copper-chromium oxide spinel by performing the XPS surface analysis on the copper-chromium oxide spinel to acquire a presence ratio (atom%) for each element and performing oxide conversion on the copper content.

In the copper-chromium oxide spinel, the copper is preferably unevenly present in the surface layer of the copper-chromium oxide spinel.

The "unevenly present in the surface layer" refers to a state in which the mass of copper or a copper compound per unit volume in the surface layer is larger than the mass of copper or a copper compound per unit volume in other than the surface layer.

In the copper-chromium oxide spinel, copper being unevenly present in the surface layer of the copper-chromium oxide spinel, as shown in the examples described below, can be determined by the fact that the content ($Cu_2$), which is determined by performing the XPS surface analysis on the copper-chromium oxide spinel, is larger than the content ($Cu_1$), which is determined by performing the XRF analysis on the copper-chromium oxide spinel.

In the copper-chromium oxide spinel, as an indicator for copper to be unevenly present in the surface layer of the copper-chromium oxide spinel, the copper-chromium oxide spinel of the embodiment has a copper surface layer uneven presence ratio ($Cu_2/Cu_1$), which is the content ($Cu_2$) determined by performing the XPS surface analysis with respect to the content ($Cu_2$) determined by the XRF analysis, of preferably greater than 1, more preferably 1.25 or more, and particularly preferably 1.5 or more and preferably 3 or less, and more preferably 2.5 or less.

By making copper or a copper compound unevenly present in the surface layer of the copper-chromium oxide spinel, copper of the activated copper-chromium oxide spinel is more exposed on the surface by laser application than when copper or a copper compound is made uniformly present not only in the surface layer but also other than the surface layer (the inner layer), resulting in more bonding points with plating and improved adhesion of plating, which is preferred.

<Method for Producing Copper-Chromium Oxide Spinel>

The method for producing a copper-chromium oxide spinel includes firing a copper compound and a chromium compound. More specifically, the method for producing a copper-chromium oxide spinel may include mixing together the copper compound and the chromium compound to form a mixture and firing the mixture, which is not limiting.

A preferred method for producing a copper-chromium oxide spinel includes a step (a mixing step) of mixing together the copper compound and the chromium compound to form the mixture and a step (a firing step) of firing the mixture.

[Mixing Step]

The mixing step is a step of mixing together the copper compound and the chromium compound to form the mixture.

The method of mixing is not limited to a particular method, and simple mixing that mixes together a powder of the copper compound and a powder of the chromium compound, mechanical mixing using a pulverizer or the like, mixing using a mortar or the like, mixing in a dry state or a wet state, and the like can be used.

For example, examples of the mixing in the wet state include a method of adding the powder of the copper compound and the powder of the chromium compound to a liquid medium and mixing them together in a stirring mill.

As the liquid medium, organic solvents, oils and fats, water, or the like can be used, and water is preferred because posttreatment is easy.

The stirring mill is not limited to a particular stirring mill so long as it is a medium stirring mill using a medium (beads, balls, or sand), and examples thereof include bead mills, ball mills, sand mills, and paint shakers. Paint shakers with balls as the medium are preferred because they are easy to handle.

The stirring time may be 5 to 240 minutes, 30 to 180 minutes, or 60 to 180 minutes from the viewpoint of being able to mix together raw materials.

For example, examples of the mixing in the dry state include manual methods such as putting the powder of the copper compound and the powder of the chromium compound in a bag, which is shaken or rubbed, and ball mills, tube mills, vibration mills, and planetary mills using a medium (beads, balls, or sand). Planetary mills with balls as the medium are preferred because they are easy to handle.

(Copper Compound)

The type of the copper compound is not limited to a particular type. For example, the copper compound may be monovalent or divalent one, and examples thereof include copper chloride, copper sulfate, copper sulfide, copper carbonate, and copper oxide. Copper carbonate and copper oxide are preferred from the viewpoint of ease of availability.

The shape of the copper-chromium oxide spinel after firing hardly reflects the shape of the copper compound as one of the raw materials, and thus as the copper compound, for example, a spherical one, an amorphous one, aspect-having structures (wires, fibers, ribbons, tubes, and the like), and sheets can also be suitably used.

(Chromium Compound)

The type of the chromium compound is not limited to a particular type. Examples of the chromium compound include chromium chloride, chromium sulfate, chromium sulfide, chromium carbonate, and chromium oxide, and chromium carbonate and chromium oxide are preferred from the viewpoint of ease of availability.

The shape of the copper-chromium oxide spinel after firing hardly reflects the shape of the chromium compound as one of the raw materials, and thus as the chromium compound, for example, a spherical one, an amorphous one, aspect-having structures (wires, fibers, ribbons, tubes, and the like), and sheets can also be suitably used.

In the method for producing a copper-chromium oxide spinel of the present invention, the molar ratio (Cu/Cr) of chromium to copper in the raw materials, for example, in the mixture, is basically 2, and the Cu/Cr may be in a range of 1.5 to 2.5 because excessive products or raw materials can be easily removed in a purification step, which will be described in detail below.

In the method for producing a copper-chromium oxide spinel, a molybdenum compound may further be used during firing. The method of production, prior to the firing step, can include a step (the mixing step) of mixing together the copper compound, the chromium compound, and the molybdenum compound to form a mixture and can include a step (the firing step) of firing the mixture.

By firing the copper compound and the chromium compound in the presence of the molybdenum compound, polyhedral particles with higher crystallinity can be obtained than when the molybdenum compound is not used, and the copper-chromium oxide spinel of desired particle size and particle size distribution can be obtained without being subjected to pulverization and/or classification steps described below, which is preferred in terms of simplifying the production steps.

<Molybdenum Compound>

Examples of the molybdenum compound include molybdenum oxide, molybdic acid, molybdenum sulfide, molybdenum silicide, silicomolybdic acid, magnesium molybdate, and molybdate compounds, and molybdenum oxide is preferred.

Examples of the molybdenum oxide include molybdenum dioxide ($MoO_2$) and molybdenum trioxide ($MoO_3$), and molybdenum trioxide is preferred.

The molybdate compounds are not limited so long as they are salt compounds of molybdenum oxoanions such as $MoO_4^{2-}$, $Mo_2O_7^{2-}$, $Mo_3O_{10}^{2-}$, $Mo_4O_{13}^{2-}$, $Mo_5O_{16}^{2-}$, $Mo_6O_{19}^{2-}$, $Mo_7O_{24}^{6-}$, and $Mo_8O_{26}^{4-}$. The molybdate compounds may be alkali metal salts, alkaline earth metal salts, or ammonium salts of molybdenum oxoanions.

Examples of the molybdate compounds include alkali metal salts of molybdenum oxoanions, and examples thereof include lithium molybdate, potassium molybdate, and sodium molybdate.

The molybdate compounds may be hydrates.

The molybdenum compound is preferably at least one compound selected from the group consisting of molybdenum trioxide, lithium molybdate, potassium molybdate, and sodium molybdate, more preferably at least one compound selected from the group consisting of molybdenum trioxide, potassium molybdate, and sodium molybdate, and particularly preferably molybdenum trioxide and sodium molybdate.

When a molybdate compound is used, a molybdate compound formed by firing in advance a mixture of molybdenum oxide and a metal chloride (for example, a metal carbonate, a halogen salt, a sulfate, or the like) may be used. For example, in the case of sodium molybdate, sodium molybdate formed by firing a mixture of molybdenum oxide and sodium carbonate can be used.

In the method for producing a copper-chromium oxide spinel, the molybdenum compound is used as a flux agent. In the present specification, this method of production using the molybdenum compound as the flux agent may be hereinafter simply referred to as the "flux method." By such firing, the copper compound, the chromium compound, and the molybdenum compound react with each other at a high temperature to partly form copper molybdate and chromium molybdate. The copper molybdate and the chromium molybdate are decomposed along with the formation of the copper-chromium oxide spinel at a high temperature, during which part of molybdenum oxide is considered to be incorporated into the copper-chromium oxide spinel. It is considered that part of molybdenum oxide evaporates to be removed from the system, but when sodium molybdate or the like is used as the molybdenum compound, the alkali metal compound and molybdenum oxide easily combine to form a molybdate again, which is hardly discharged out of the system and remains in the system.

It is considered that when, for example, sodium molybdate is used in the flux method, copper molybdate and chromium molybdate decompose in the presence of sodium molybdate in a liquid phase, copper chromite is formed and then subjected to crystal growth, and thereby the copper-chromium oxide spinels with a low degree of flocculation or no flocculation can be easily obtained while inhibiting the evaporation of the flux (the sublimation of $MoO_3$) described above. It is assumed that the above effects can be achieved with the molybdenum compound or the like as well.

In the method for producing a copper-chromium oxide spinel, the blending amounts of the copper compound, the chromium compound, and the molybdenum compound used are not limited to particular amounts, and the molybdenum compound may be blended in an amount of 1 to 1,000 parts by mass or blended in an amount of 5 to 100 parts by mass with respect to 100 parts by mass of the total blending amount of the copper compound and the chromium compound in the raw materials, for example, in the mixture.

In the method for producing a copper-chromium oxide spinel, the value of the molar ratio (molybdenum/(copper + chromium)) between the molybdenum atoms in the molybdenum compound and the copper and chromium atoms in the copper compound and the chromium compound in the raw materials, for example, in the mixture is preferably 0.001 or more, more preferably 0.003 or more, even more preferably 0.01 or more, and particularly preferably 0.02 or more.

The upper limit of the molar ratio between the molybdenum atoms in the molybdenum compound and the copper and chromium atoms in the copper compound and the chromium compound in the raw materials, for example, in the mixture may be set as appropriate, and from the viewpoint of a reduction in the amount of the molybdenum compound used and improvement in production efficiency, for example, the value of the molar ratio (molybdenum/(copper + chromium)) may be 1 or less, 0.5 or less, 0.2 or less, or 0.1 or less.

As an example of the numerical range of the molar ratio (molybdenum/(copper + chromium)) in the raw materials, for example, in the mixture, for example, the value of molybdenum/(copper + chromium) may be 0.001 to 1, 0.003 to 0.5, 0.01 to 0.2, or 0.02 to 0.1.

By using the various compounds within the above range, the copper-chromium oxide spinel to be obtained can be made to have desired particle size and particle size distribution without being subjected to the pulverization and/or classification steps described below.

(Other Additives)

In the method for producing a copper-chromium oxide spinel, a sodium compound and/or a potassium compound may further be used.

In the method of production, by using the sodium compound and/or the potassium compound in combination, it is easy to adjust the particle size of the copper-chromium oxide spinel to be produced, and the copper-chromium oxide spinel with a low degree of flocculation or no flocculation can be easily produced.

Here, when the molybdenum compound is used as the flux agent, a compound containing molybdenum and sodium, such as sodium molybdate, can also be used instead of at least part of the molybdenum compound and the sodium compound. Similarly, a compound containing molybdenum and potassium, such as potassium molybdate, can also be used instead of at least part of the molybdenum compound and the potassium compound.

The compound containing molybdenum and sodium, which is suitable as the flux agent, can be produced, for example, in the process of firing with the molybdenum compound and the sodium compound, which are lower in price and more readily available, as raw materials. In this example, both the case in which the molybdenum compound and the sodium compound are used as the flux agent and the case in which the compound containing molybdenum and sodium is used as the flux agent are regarded as the case in which the molybdenum compound and the sodium compound are used as the flux agent, that is, in the presence of the molybdenum compound and the sodium compound.

The compound containing molybdenum and potassium, which is suitable as the flux agent, can be produced, for example, in the process of firing with the molybdenum compound and the potassium compound, which are lower in price and more readily available, as raw materials. In this example, both the case in which the molybdenum compound and the potassium compound are used as the flux agent and the case in which the compound containing molybdenum and potassium is used as the flux agent are regarded as the case in which the molybdenum compound and the potassium compound are used as the flux agent, that is, in the presence of the molybdenum compound and the potassium compound.

(Sodium Compound)

The sodium compound is not limited to a particular sodium compound, and examples thereof include sodium carbonate, sodium molybdate, sodium oxide, sodium sulfate, sodium hydroxide, sodium nitrate, sodium chloride, and metallic sodium. Among these, sodium carbonate, sodium molybdate, sodium oxide, and sodium sulfate are preferably used from the viewpoint of ease of industrial availability and ease of handling.

Note that the sodium compounds described above may be used alone or in combination of two or more thereof.

Similarly to the above, sodium molybdate contains molybdenum and can thus also have the function as the molybdenum compound described above.

(Potassium Compound)

The potassium compound is not limited to a particular potassium compound, and examples thereof include potassium chloride, potassium chlorite, potassium chlorate, potassium sulfate, potassium hydrogen sulfate, potassium sulfite, potassium hydrogen sulfite, potassium nitrate, potassium carbonate, potassium hydrogencarbonate, potassium acetate, potassium oxide, potassium bromide, potassium bromate, potassium hydroxide, potassium silicate, potassium phosphate, potassium hydrogen phosphate, potassium sulfide, potassium hydrogen sulfide, potassium molybdate, and potassium tungstate. In this case, the potassium compounds include isomers, as in the case of the molybdenum compounds. Among these, potassium carbonate, potassium hydrogencarbonate, potassium oxide, potassium hydroxide, potassium chloride, potassium sulfate, and potassium molybdate are preferably used, and potassium carbonate, potassium hydrogencarbonate, potassium chloride, potassium sulfate, and potassium molybdate are more preferably used.

Note that the potassium compounds described above may be used alone or in combination of two or more thereof.

Similarly to the above, potassium molybdate contains molybdenum and can thus also have the function as the molybdenum compound described above.

(Metal Compound)

In the method for producing a copper-chromium oxide spinel, a metal compound may further be used during firing if desired.

The metal compound is not limited to a particular metal compound and preferably contains at least one selected from the group consisting of Group II metal compounds and Group III metal compounds.

Examples of the Group II metal compounds include calcium compounds, strontium compounds, and barium compounds.

Examples of the Group III metal compounds include scandium compounds, yttrium compounds, lanthanum compounds, and cerium compounds.

The metal compounds described above mean oxides, hydroxides, carbonates, and chlorides of metal elements. For example, examples of the yttrium compounds include yttrium oxide ($Y_2O_3$), yttrium hydroxide, and yttrium carbonate. Among these, the metal compounds are preferably oxides of metal elements. Note that these metal compounds include isomers.

Among these, the metal compound is preferably a metal compound of third-period elements, a metal compound of fourth-period elements, a metal compound of fifth-period elements, or a metal compound of sixthperiod elements, more preferably a metal compound of fourth-period elements or a metal compound of fifth-period elements, and even more preferably a metal compound of fifth-period elements. Specifically, calcium compounds, yttrium compounds, and lanthanum compounds are preferably used, calcium compounds and yttrium compounds are more preferably used, and yttrium compounds are particularly preferably used.

The metal compound is preferably used at a ratio of, for example, 0 to 1.2% by mass (for example, 0 to 1 mol%) with respect to the total amount of the chromium compound used in the mixing step.

[Firing Step]

The firing step is a step of firing the mixture. The copper-chromium oxide spinel according to the embodiment is obtained by firing the mixture.

The state of the copper compound and the chromium compound during firing is not limited to a particular state, and it is only required that they are present in the same space.

There is no particular limitation on the condition of the firing temperature, which is determined as appropriate taking into consideration the target particle size, particle size distribution, shape, and the like of the copper-chromium oxide spinel. The firing temperature may be 800°C or higher, 900°C or higher, or 1,200°C or higher. A higher firing temperature controls the shape of the copper-chromium oxide spinel, which is preferred.

From the viewpoint of production efficiency, the temperature rising rate may be 20 to 600°C/h, 40 to 500°C/h, 100 to 400°C/h, or 200 to 400°C/h.

As to the time of firing, the temperature rising time to a certain firing temperature is preferably performed in a range of 15 minutes to 10 hours. The holding time at the firing temperature can be 5 minutes or longer and is preferably performed in a range of 5 minutes to 30 hours. To efficiently perform the formation of the copper-chromium oxide spinel, a firing temperature holding time of 2 hours or longer is more preferred, and a firing temperature holding time of 2 to 15 hours is particularly preferred.

The atmosphere of firing is not limited to a particular atmosphere so long as the effects of the present invention are obtained, and, for example, an oxygen-containing atmosphere such as air or oxygen or an inert atmosphere such as nitrogen, argon, or carbon dioxide is preferred, and an air atmosphere is more preferred when the aspect of cost is considered.

The apparatus for firing is not necessarily limited, and what is called a firing furnace can be used. Examples thereof include roller hearth kilns, pusher kilns, rotary kilns, tunnel kilns, and shuttle kilns.

When the molybdenum compound is used as the flux agent, as in conventional flux methods, crystal growth can be performed at temperatures much lower than the melting point of the target compound, with the advantage that the crystal shape and/or the particle size distribution can precisely be controlled.

When the molybdenum compound is used, the state of the copper compound, the chromium compound, and the molybdenum compound during firing is not limited to a particular state, and it is only required that the molybdenum compound is present in the same space in which it can act on the copper compound and the chromium compound.

When the molybdenum compound is used, there is no particular limitation on the condition of the firing temperature, which is determined as appropriate taking into consideration the target particle size, particle size distribution, shape, and the like of the copper-chromium oxide spinel. The firing temperature may be 800°C or higher, 800°C or higher, or 900°C or higher.

When the molybdenum compound is used, even under conditions in which, for example, the highest firing temperature at which the copper compound and the chromium compound are fired is 1,500°C or lower, the formation of the copper-chromium oxide spinel can be performed efficiently at low cost.

Even when the firing temperature is a temperature much lower than 1,500°C, the copper-chromium oxide spinel having automorphism can be formed regardless of the shape of the precursor. From the viewpoint of efficiently producing the copper-chromium oxide spinel, the firing temperature may be 1,500°C or lower or 1,000°C or lower.

When the molybdenum compound is used, the numerical range of the firing temperature at which the copper compound and the chromium compound are fired in the firing step may be, as an example, 700 to 1,500°C, 800 to 1,200°C, 900 to 1,000°C, or 950 to 1,000°C.

When the molybdenum compound is used, the temperature rising rate may be 20 to 600°C/h, 40 to 500°C/h, 100 to 400°C/h, or 200 to 400°C/h from the viewpoint of production efficiency.

Being within the above range tends to provide particles of narrower particle size distribution.

When the molybdenum compound is used, as to the time of firing, the temperature rising time to a certain firing temperature is preferably performed in a range of 15 minutes to 10 hours. The holding time at the firing temperature can be 5 minutes or longer and is preferably performed in a range of 5 minutes to 30 hours. To efficiently perform the formation of the copper-chromium oxide spinel, a firing temperature holding time of 2 hours or longer is more preferred, and a firing temperature holding time of 2 to 15 hours is particularly preferred.

The atmosphere of firing is not limited to a particular atmosphere so long as the effects of the present invention are obtained, and, for example, an oxygen-containing atmosphere such as air or oxygen or an inert atmosphere such as nitrogen, argon, or carbon dioxide is preferred, and an air atmosphere is more preferred when the aspect of cost is considered.

When the molybdenum compound is used, the apparatus for firing is not necessarily limited, and what is called a firing furnace can be used. The firing furnace is preferably made of a material that does not react with molybdenum oxide that has sublimated, and furthermore, a highly sealed firing furnace is preferably used so that molybdenum oxide is efficiently utilized.

[Cooling Step]

The method for producing a copper-chromium oxide spinel may include a cooling step. The cooling step is a step of cooling the copper-chromium oxide spinel that has undergone crystal growth in the firing step.

The cooling rate, which is not limited to a particular rate, is preferably 1 to 1,000°C/hour, more preferably 5 to 500°C/hour, and even more preferably 50 to 100°C/hour. When the cooling rate is 1°C/hour or more, the production time can be reduced, which is preferred. On the other hand, when the cooling rate is 1,000°C/hour or less, a firing vessel is less likely to break due to heat shock and can be used for a long term, which is preferred.

The method of cooling, which is not limited to a particular method of cooling, may be either natural cooling or use a cooling apparatus.

[Posttreatment Step]

When molybdenum is used in the method for producing a copper-chromium oxide spinel, it may further include a posttreatment step of removing at least part of the molybdenum as needed after the firing step.

Examples of the method include washing and high-temperature treatment. These can be performed in combination.

Molybdenum can adhere to the surface of the copper-chromium oxide spinel. The molybdenum can be removed by washing with water, an aqueous ammonia solution, an aqueous sodium hydroxide solution, or the like.

In this process, by changing as appropriate the concentration of water, the aqueous ammonia solution, and the aqueous sodium hydroxide solution used, the amount of them used, the washing part, the washing time, and the like, the molybdenum content in the copper-chromium oxide spinel can be controlled.

Examples of the method of high-temperature treatment include a method of raising the temperature to the sublimation point or the boiling point of the molybdenum compound or higher.

[Pulverization Step]

A fired product obtained through the firing step may not meet the optimal particle size range for the use under consideration due to flocculation of the copper-chromium oxide spinel. Thus, the copper-chromium oxide spinel may be pulverized to meet the suitable particle size range as needed.

The method for pulverizing the fired product is not limited to a particular method, and conventionally known methods of pulverization, such as ball mills, jaw crushers, jet mills, disk mills, spectro mills, grinders, and mixer mills, can be used.

[Classification Step]

The fired product containing the copper-chromium oxide spinel obtained by the firing step may be subjected to classification processing as appropriate to adjust the particle size range. The "classification processing" refers to the operation of grouping particles according to the size of the particles.

Classification may be either wet type or dry type, and from the viewpoint of productivity, dry classification is preferred.

Dry classification includes classification with a sieve and wind classification, which performs classification through the difference between centrifugal force and fluid drag force. From the viewpoint of classification accuracy, wind classification is preferred, which can be performed using classifiers such as airflow classifiers utilizing the Coanda effect, swirling airflow type classifiers, forced vortex centrifugal classifiers, and semi-free vortex centrifugal classifiers.

The pulverization step and the classification step described above can be performed at necessary stages. By the presence or absence of these pulverization and classification and the selection of conditions for those, for example, the average particle size of the copper-chromium oxide spinel to be obtained can be adjusted.

The copper-chromium oxide spinel of the embodiment or the copper-chromium oxide spinel obtained by the method of production of the embodiment has a low degree of flocculation or no flocculation and is thus preferred from the viewpoint of easily exhibiting its original properties, being more excellent in its own handleability, and being more excellent in dispersibility when it is used dispersed in a dispersed medium.

When molybdenum is used in the method for producing a copper-chromium oxide spinel, it can easily produce a copper-chromium oxide spinel with a low degree of flocculation or no flocculation and thus has an excellent advantage that a copper-chromium oxide spinel having desired excellent properties can be produced with high productivity even without performing the pulverization step or the classification step.

(Uses)

The copper-chromium oxide spinel of the present invention has precisely controlled particle size and particle size distribution and can thus suitably be used in catalysts and resin compositions. Specific examples of its uses include, but not limited to, synthetic reaction catalysts, exhaust gas purification catalysts, heat-resistant pigments, and resin compositions for LDS.

<Resin Composition>

The copper-chromium oxide spinel of the present invention can suitably be used for resin compositions and in particular can suitably be used as resin compositions for LDS. Specifically, as a method for obtaining a resin composition from the copper-chromium oxide spinel of the present invention, it is obtained by thoroughly melting and kneading the copper-chromium oxide spinel, a thermoplastic resin, and an inorganic filler until becoming uniform using an extruder, a kneader, a roll, or the like as needed and cooling the kneaded product. The shape of the resin composition to be obtained may be any shape such as a pellet shape when the thermoplastic resin is used and may be pulverized to an appropriate size and made into a tablet shape with a tabletting machine or the like when a thermosetting resin is used.

The resin composition for LDS may further contain clay minerals, fillers, coupling agents, and other additives as optional components.

The content of the copper-chromium oxide spinel in the resin composition may be contained in an amount of more than 0 part by mass, preferably 1 part by mass or more, and more preferably 5 parts by mass or more as a lower limit and may be preferably less than 30 parts by mass and more preferably less than 20 mass parts as an upper limit with respect to 100 parts by mass of the resin composition. Being within the above range can achieve good platability of a molded article to be obtained.

The thermoplastic resin is not limited to a particular thermoplastic resin, and examples thereof include polyester resins, polyarylene sulfide resins, polyamide resins, polyimide resins, polyetherimide resins, polycarbonate resins, polyphenylene ether resins, polysulfone resins, polyethersulfone resins, polyetheretherketone resins, polyetherketone resins, polyarylene resins, syndiotactic polystyrene resins, polyethylene resins, polypropylene resins, polytetrafluoroethylene resins, polyvinylidene fluoride resins, polystyrene resins, acrylonitrile-butadienestyrene (ABS) resins, phenolic resins, urethane resins, and liquid crystal polymers. These resins may be used alone or in combination of two or more thereof. Among these, preferred are polyarylene sulfide resins, polyamide resins, polyetherimide resins, polycarbonate resins, polyphenylene ether resins, polysulfone resins, polyethersulfone resins, polyetheretherketone resins, polyetherketone resins, polyarylene resins, and syndiotactic polystyrene resins, and from the viewpoint of maintaining the adhesion of plating, polyarylene sulfide resins and polyamide resins, which have high laser sensitivity, are particularly preferred.

The thermosetting resin is not limited to a particular thermosetting resin, and examples thereof include epoxy resins, phenolic resins, oxetane resins, (meth)acrylate resins, unsaturated polyester resins, diaryl phthalate resins, and maleimide resins. These resins may be used alone or in combination of two or more thereof. Among these, from the viewpoint of improving curability, preservability, heat resistance, moisture resistance, and chemical resistance, epoxy resins are particularly preferred.

The blending ratio of the thermoplastic resin or the thermosetting is in a range from preferably 5% by mass or more and more preferably 10% by mass or more to preferably 40% by mass or less and more preferably 20% by mass or less with respect to the entire mass of the resin composition. When the blending ratio of the thermoplastic resin or the thermosetting resin with respect to the entire mass of the resin composition is 5% by mass or more, the plating deposition rate of the molded article to be obtained can be improved, which is preferred. In addition, from the viewpoint of the adhesion of the plating of the molded article to be obtained and the viewpoint of filling properties and molding stability, the blending ratio is preferably 40% by mass or less.

Examples of the inorganic filler include fused silica, crystalline silica, cristobalite, alumina, silicon nitride, aluminum nitride, aluminum hydroxide, boron nitride, titanium oxide, glass fibers, alumina fibers, zinc oxide, talc, and calcium carbide. These inorganic fillers may be used alone or in combination of two or more thereof. From the viewpoint of improvement in the dispersibility of the resin composition, fused silica and crystalline silica are more preferred, and from the viewpoint of improvement in the mechanical strength of the molded article, glass fibers are more preferred.

The resin composition can blend clay minerals as an optional component. The clay minerals, exhibiting a synergistic effect with the copper-chromium oxide spinel of the present invention, has the function of improving the plating properties of the molded article to be obtained and the bonding strength of a plating layer. From the viewpoint of obtaining a practical plating deposition rate for the molded article to be obtained, the clay minerals are preferably uniformly contained in the resin composition as is the case with the copper-chromium oxide spinel.

For the clay minerals, layered and cleavable ones are used. The clay minerals are not limited to particular clay minerals, and examples thereof include carbonate minerals and silicate minerals.

The fillers are not limited to particular fillers, and examples thereof include fibrous fillers such as carbon fibers, silane glass fibers, ceramic fibers, aramid fibers, metal fibers, potassium titanate fibers, silicon carbide fibers, and calcium silicate (wollastonite); and non-fibrous fillers such as glass beads, glass flakes, barium sulfate, clay, pyrophyllite, bentonite, sericite, attapulgite, ferrite, calcium silicate, calcium carbonate, magnesium carbonate, glass beads, zeolite, and calcium sulfate. These fillers may be used alone or in combination of two or more thereof. These fillers have functions such as further imparting mechanical strength to the molded article.

Examples of the coupling agents include, as silane coupling agents, epoxy group-containing alkoxysilane compounds such as γ-glycidoxypropyltrimethoxysilane, γ-glycidoxypropyltriethoxysilane, and β-(3,4-epoxycyclohexyl) ethyltrimethoxysilane; isocyanato group-containing alkoxysilane compounds such as γ-isocyanatopropyltrimethoxysilane, γ-isocyanatopropyltriethoxysilane, γ-isocyanatopropylmethyldimethoxysilane, γ-isocyanatopropylmethyldiethoxysilane, γ-isocyanatopropylethyldimethoxysilane, γ-isocyanatopropylethyldiethoxysilane, and γ-isocyanatopropyltrichlorosilane; amino group-containing alkoxysilane compounds such as γ-(2-aminoethyl)aminopropylmethyldimethoxysilane, γ-(2-aminoethyl) aminopropyltrimethoxysilane, and γ-aminopropyltrimethoxysilane; and hydroxy group-containing alkoxysilane compounds such as γ-hydroxypropyltrimethoxysilane and γ-hydroxypropyltriethoxysilane. These silane coupling agents may be used alone or in combination of two or more thereof. These coupling agents have the function of imparting mechanical strength, apart from imparting adhesion to different materials, to the molded article.

Examples of the other additives include curing agents, curing accelerators, mold release agents, flame retardants, light stabilizers, heat stabilizers, alkalis, elastomers, titanium oxide, antioxidants, hydrolysis resistance modifiers, matting agents, UV absorbers, nucleating agents, plasticizers, dispersants, antistatic agents, coloring inhibitors, gelation inhibitors, and colorants.

<Resin Molded Article>

The method for obtaining a resin molded article from the resin composition of the present invention is not limited to a particular method, and known methods can be employed as appropriate, and examples thereof include mold molding such as injection molding, injection compression molding, and transfer molding, extrusion molding, sheet molding, thermoforming, rotational molding, laminate molding, press molding, blow molding, and melt molding.

The obtained molded article is suitably used for wiring and circuits for built-in antennas, touch sensors, and chip packages because the surface layer of the molded article is roughened by laser direct structuring on the surface or the inside, plating treatment is applied, and thereby plating can be deposited only on a roughened area.

Examples of the method for roughening the surface layer include lasers. The wavelength of the laser can be selected as appropriate from the range of 150 to 12,000 nm and is preferably 185 nm, 248 nm, 254 nm, 308 nm, 355 nm, 532 nm, 1,064 nm, or 10,600 nm.

The plating treatment may be either electrolytic plating or electroless plating. The laser application described above roughens the surface layer of the molded article, exposing part of the activated copper-chromium oxide spinel in the resin composition. With this, during the plating treatment, plating is deposited only on the roughened area, and circuits or the like can be formed. As a plating solution, known plating solutions can be used as appropriate without any particular limitation, and plating solutions containing required metal components such as Cu, Ni, and Ag can be used.

The method for determining whether the copper-chromium oxide spinel of the present invention can suitably be used for LDS uses is not limited to a particular method, and it can be evaluated by, for example, observing flocculated particles in a dispersion liquid, observing metallic element distribution in the dispersion liquid, and measuring the surface roughness of a resin cured product.

Examples of the method for directly observing the flocculated particles in the dispersion liquid include a method of producing a dispersion liquid containing the copper-chromium oxide spinel of the present invention, a resin, and a solvent and then visually observing the dispersion liquid to determine the presence or absence of flocculates of the copper-chromium oxide spinel. When no flocculates are observed, it can be evaluated as "good dispersibility (hereinafter O)", and when flocculates are observed, it can be evaluated as "faulty dispersibility (hereinafter X)."

As the resin, which is not limited to a particular resin, the thermosetting resins and the thermoplastic resins described above are used, for example. A dispersant can also be used in place of the resin. As the dispersant, known dispersants can be used as appropriate, and examples thereof include polymer dispersants such as urethane-based dispersants, acrylic dispersants, polyethyleneimine-based dispersants, polyarylamine-based dispersants, polyoxyethylene alkyl ether-based dispersants, polyoxyethylene diester-based dispersants, polyether phosphoric acid-based dispersants, polyester phosphoric acid-based dispersants, sorbitan aliphatic ester-based dispersants, and aliphatic modified polyester-based dispersants. Note that the resin and the dispersant may be used in combination, or the dispersion liquid may be prepared only with the solvent and the copper-chromium oxide spinel without using the resin or the dispersant.

The solvent may be an organic solvent or water. The organic solvent is not limited to a particular organic solvent, and examples thereof include alcohols such as methanol, ethanol, propanol, isopropyl alcohol, butanol, hexanol, heptanol, octanol, decanol, cyclohexanol, terpineol, and 1-methoxy-2-propanol; glycols such as ethylene glycol and propylene glycol; ketones such as acetone, ethyl ketone, methyl ethyl ketone, and diethyl ketone; esters such as ethyl acetate, butyl acetate, and benzyl acetate; ether alcohols such as methoxyethanol and ethoxyethanol; ethers such as dioxane and tetrahydrofuran; acid amides such as N,N-dimethylformamide; aromatic hydrocarbons such as benzene, toluene, xylene, trimethylbenzene, and dodecylbenzene; organochlorine compounds such as chloroform, chlorobenzene, and ortho-dichlorobenzene; long chain alkanes such as hexane, heptane, octane, nonane, decane, undecane, dodecane, tridecane, tetradecane, pentadecane, hexadecane, octadecane, nonadecane, eicosane, and trimethylpentane; and cyclic alkanes such as cyclohexane, cycloheptane, cyclooctane, and decalin.

As the method of dispersion, methods performing mixing using dispersing machines such as paint conditioners, bead mills, ball mills, blender mills, three-roll mills, and ultrasonic homogenizers can be used.

The dispersion state can be determined by producing a resin cured product and calculating the roughness of the surface of the cured product. Unevenness occurring on the surface of the cured product means the presence of flocculates (secondary particles) or coarse particles (primary particles) due to inadequate control of particle size and particle size distribution.

The resin cured product can be produced based on the methods described for the resin composition and the resin molded article described above.

The method for measuring the roughness of the surface can be performed in accordance with JIS B0601 (1994).

The roughness of the surface can also be evaluated by observing the surface state of a coating obtained by dropping or applying a composition for color spreading, which is a mixture of the copper-chromium oxide spinel, a water-soluble binder, a dispersant, and a defoaming agent, onto a base material and then curing it.

Examples of the water-soluble binder include styrene acrylic resin emulsions, (meth)acrylate resin emulsions, and polybutadiene resin emulsions.

Examples of the dispersant include phosphate-based ones, among which sodium hexametaphosphate and sodium pyrophosphate are preferred.

Preferred examples of the defoaming agent include silicone defoaming agents, and any ones such as emulsification dispersion type ones and solubilization type ones can be used.

The method for evaluating dispersibility may be either visual evaluation or metal elemental analysis. In the former case, if vertical streaks (color unevenness) occur in the coating, it can be determined to be faulty dispersibility. In the latter case, variations in elements are evaluated from profiles showing the peak intensity of Cu and Cr, and if they are unevenly present in a part, it can be determined to be faulty dispersibility.

[Examples]

The following describes the present invention more specifically by means of examples and comparative examples. In the following, "parts" and "%" are on a mass basis unless otherwise noted. A copper-chromium oxide spinel was synthesized under the following conditions, and measurement or calculation and evaluation were performed under the following conditions.

<Synthesis of Copper-Chromium Oxide Spinel>

(Example 1)

Copper oxide (II) (a reagent manufactured by Kanto Chemical Co., Inc., CuO) in an amount of 7.95 parts, 15.20 parts of chromium oxide (III) (a reagent manufactured by Kanto Chemical Co., Inc., $Cr_2O_3$), 1.16 parts of molybdenum trioxide (manufactured by Nippon Inorganic Colour & Chemical Co., Ltd.), 30 parts of ion exchanged water, and 120 parts of zirconia beads 5 mm in diameter were charged into a 100 ml polypropylene bottle and mixed together and pulverized using a paint shaker for 120 minutes to obtain a mixture. The obtained mixture was transferred to a metal vat and dried in an oven at 120°C, and the dried object was pulverized with a mixer (manufactured by Osaka Chemical Co., Ltd.). The pulverized raw materials were put into a crucible and fired in a ceramic electric furnace at 950°C for 10 hours. Note that the temperature was raised at 5°C/minute. After the temperature was lowered, the crucible was taken out to obtain a black powder. Subsequently, the black powder was dispersed in 300 mL of 0.25% ammonia water, and the dispersion solution was stirred at room temperature (25 to 30°C) for 2 hours, passed through a 100 $\mu$m sieve, filtered to remove the ammonia water, washed with water, and dried to obtain a copper-chromium oxide spinel. Note that the particles were subjected to XRF and XPS analysis to show $Mo_1$ of 0.2% by mass, $Mo_2$ of 5.4% by mass, $Cu_1$ of 33.7% by mass, and $Cu_2$ of 62.7% by mass.

(Example 2)

A copper-chromium oxide spinel was obtained in the same manner as in Example 1 except that the amount of molybdenum trioxide used was changed to 2.32 parts. Note that the particles were subjected to XRF and XPS analysis to show $Mo_1$ of 0.3% by mass, $Mo_2$ of 3.9% by mass, $Cu_1$ of 33.4% by mass, and $Cu_2$ of 71.7% by mass.

(Example 3)

A mixture of 38.6 parts of sodium molybdate dihydrate (a reagent manufactured by Kanto Chemical Co., Inc.) and 14.4 parts of molybdenum trioxide (manufactured by Nippon Inorganic Colour & Chemical Co., Ltd.) was placed in a crucible and was fired in a ceramic electric furnace at 700°C for 5 hours. $Na_2Mo_2O_7$ in an amount of 49.0 parts was obtained.
Copper oxide (II) (a reagent manufactured by Kanto Chemical Co., Inc., CuO) in an amount of 7.95 parts, 15.20 parts of chromium oxide (III) (a reagent manufactured by Kanto Chemical Co., Inc., $Cr_2O_3$), 2.32 parts of $Na_2Mo_2O_7$ described above, 30 parts of ion exchanged water, and 120 parts of zirconia beads 5 mm in diameter were charged into a 100 ml polypropylene bottle and mixed together and pulverized using a paint shaker for 120 minutes to obtain a mixture. The obtained mixture was transferred to a metal vat and dried in an oven at 120°C, and the dried object was pulverized with a mixer (manufactured by Osaka Chemical Co., Ltd.). The pulverized raw materials were put into a crucible and fired in a ceramic electric furnace at 950°C for 10 hours. Note that the temperature was raised at 5°C/minute. After the temperature was lowered, the crucible was taken out to obtain a black powder. Subsequently, the black powder was dispersed in 300 mL of 0.25% ammonia water, and the dispersion solution was stirred at room temperature (25 to 30°C) for 2 hours, passed through a 100 $\mu$m sieve, filtered to remove the ammonia water, washed with water, and dried to obtain a copper-chromium oxide spinel. Note that the particles were subjected to XRF and XPS analysis to show $Mo_1$ of 0.1% by mass, $Mo_2$ of 0.8% by mass, $Cu_1$ of 33.3% by mass, and $Cu_2$ of 64.4% by mass.

(Example 4)

Copper oxide (II) (a reagent manufactured by Kanto Chemical Co., Inc., CuO) in an amount of 7.95 parts, 15.20 parts of chromium oxide (III) (a reagent manufactured by Kanto Chemical Co., Inc., $Cr_2O_3$), 1.16 parts of molybdenum trioxide (manufactured by Nippon Inorganic Colour & Chemical Co., Ltd.), 30 parts of ion exchanged water, and 120 parts of zirconia beads 5 mm in diameter were charged into a 100 ml polypropylene bottle and mixed together and pulverized using a paint shaker for 120 minutes to obtain a mixture. The obtained mixture was transferred to a metal vat and dried in an oven at 120°C, and the dried object was pulverized with a mixer (manufactured by Osaka Chemical Co., Ltd.). The pulverized raw materials were put into a crucible and fired in a ceramic electric furnace at 900°C for 10 hours. Note that the temperature was raised at 5°C/minute. After the temperature was lowered, the crucible was taken out to obtain a black powder. Subsequently, the black powder was dispersed in 300 mL of 0.25% ammonia water, and the dispersion solution was stirred at room temperature (25 to 30°C) for 2 hours, passed through a 100 $\mu$m sieve, filtered to remove the ammonia water, washed with water, and dried to obtain a copper-chromium oxide spinel. Note that the particles were subjected to XRF and XPS analysis to show $Mo_1$ of 0.1% by mass, $Mo_2$ of 0.3% by mass, $Cu_1$ of 32.9% by mass, and $Cu_2$ of 55.9% by mass.

(Example 5)

Copper oxide (II) (a reagent manufactured by Kanto Chemical Co., Inc., CuO) in an amount of 7.95 parts, 15.20 parts of chromium oxide (III) (a reagent manufactured by Kanto Chemical Co., Inc., $Cr_2O_3$), 2.32 parts of molybdenum trioxide (manufactured by Nippon Inorganic Colour & Chemical Co., Ltd.), 30 parts of ion exchanged water, and 120 parts of zirconia beads 5 mm in diameter were charged into a 100 ml polypropylene bottle and mixed together and pulverized using a paint shaker for 120 minutes to obtain a mixture. The obtained mixture was transferred to a metal vat and dried in an oven at 120°C, and the dried object was pulverized with a mixer (manufactured by Osaka Chemical Co., Ltd.). The pulverized raw materials were put into a crucible and fired in a ceramic electric furnace at 950°C for 10 hours. Note that the temperature was raised at 5°C/minute. After the temperature was lowered, the crucible was taken out to obtain a black powder. Subsequently, the black powder was dispersed in 300 mL of 0.25% ammonia water, and the dispersion solution was stirred at room temperature (25 to 30°C) for 2 hours, passed through a 100 $\mu$m sieve, filtered to remove the ammonia water, washed with water, and dried to obtain a copper-chromium oxide spinel. Note that the particles were subjected to XRF and XPS analysis to show $Mo_1$ of 0.2% by mass, $Mo_2$ of 2.7% by mass, $Cu_1$ of 33.2% by mass, and $Cu_2$ of 61.6% by mass.

(Example 6)

A mixture of 38.6 parts of sodium molybdate dihydrate (a reagent manufactured by Kanto Chemical Co., Inc.) and 14.4 parts of molybdenum trioxide (manufactured by Nippon Inorganic Colour & Chemical Co., Ltd.) was placed in a crucible and was fired in a ceramic electric furnace at 700°C for 5 hours. $Na_2Mo_2O_7$ in an amount of 49.0 parts was obtained.

Copper oxide (II) (a reagent manufactured by Kanto Chemical Co., Inc., CuO) in an amount of 7.95 parts, 15.20 parts of chromium oxide (III) (a reagent manufactured by Kanto Chemical Co., Inc., $Cr_2O_3$), 2.32 parts of $Na_2Mo_2O_7$ described above, 30 parts of ion exchanged water, and 120 parts of zirconia beads 5 mm in diameter were charged into a 100 ml polypropylene bottle and mixed together and pulverized using a paint shaker for 120 minutes to obtain a mixture. The obtained mixture was transferred to a metal vat and dried in an oven at 120°C, and the dried object was pulverized with a mixer (manufactured by Osaka Chemical Co., Ltd.). The pulverized raw materials were put into a crucible and fired in a ceramic electric furnace at 900°C for 10 hours. Note that the temperature was raised at 5°C/minute. After the temperature was lowered, the crucible was taken out to obtain a black powder. Subsequently, the black powder was dispersed in 300 mL of 0.25% ammonia water, and the dispersion solution was stirred at room temperature (25 to 30°C) for 2 hours, passed through a 100 $\mu$m sieve, filtered to remove the ammonia water, washed with water, and dried to obtain a copper-chromium oxide spinel. Note that the particles were subjected to XRF and XPS analysis to show $Mo_1$ of 0.1% by mass, $Mo_2$ of 0.9% by mass, $Cu_1$ of 33.4% by mass, and $Cu_2$ of 51.2% by mass.

(Comparative Example 1)

Copper oxide (II) (a reagent manufactured by Kanto Chemical Co., Inc., CuO) in an amount of 7.95 parts, 15.20 parts of chromium oxide (III) (a reagent manufactured by Kanto Chemical Co., Inc., $Cr_2O_3$), 30 parts of ion exchanged water, and 120 parts of zirconia beads 5 mm in diameter were charged into a 100 ml polypropylene bottle and mixed together and pulverized using a paint shaker for 120 minutes to obtain a mixture. The obtained mixture was transferred to a metal vat and dried in an oven at 120°C, and the dried object was pulverized with a mixer (manufactured by Osaka Chemical Co., Ltd.). The pulverized raw materials were put into a crucible and fired in a ceramic electric furnace at 900°C for 10 hours. Note that the temperature was raised at 5°C/minute. After the temperature was lowered, the crucible was taken out to obtain a dark green powder. Subsequently, the dark green powder was dispersed in 300 mL of 0.25% ammonia water, and the dispersion solution was stirred at room temperature (25 to 30°C) for 2 hours, passed through a 100 $\mu$m sieve, filtered to remove the ammonia water, washed with water, and dried to obtain a dark green powder.

(Comparative Example 2)

Copper oxide (II) (a reagent manufactured by Kanto Chemical Co., Inc., CuO) in an amount of 4.78 parts, 15.00 parts of chromium oxide (III) (a reagent manufactured by Kanto Chemical Co., Inc., $Cr_2O_3$), 0.02 part of molybdenum trioxide (manufactured by Nippon Inorganic Colour & Chemical Co., Ltd.), 0.20 part of zinc oxide (a reagent manufactured by Kanto Chemical Co., Inc., ZnO), 30 parts of ion exchanged water, and 120 parts of zirconia beads 5 mm in diameter were charged into a 100 ml polypropylene bottle and mixed together and pulverized using a paint shaker for 120 minutes to obtain a mixture. The obtained mixture was transferred to a metal vat and dried in an oven at 120°C, and the dried object was pulverized with a mixer (manufactured by Osaka Chemical Co., Ltd.). The pulverized raw materials were put into a crucible and fired in a ceramic electric furnace at 900°C for 10 hours. Note that the temperature was raised at 5°C/minute. After the temperature was lowered, the crucible was taken out to obtain a black powder. Subsequently, the black powder was dispersed in 300 mL of 0.25% ammonia water, and the dispersion solution was stirred at room temperature (25 to 30°C) for 2 hours, passed through a 100 $\mu$m sieve, filtered to remove the ammonia water, washed with water, and dried to obtain a copper-chromium oxide spinel. Note that the particles were subjected to XRF and XPS analysis to show $Mo_1$ of 0.1% by mass and $Mo_2$ of 10.0% by mass.

[Particle Size Distribution Measurement]

The particle size distribution of the sample powder was measured in dry form using a laser diffraction type dry particle size distribution analyzer (HELOS (H3355) & RODOS manufactured by Japan Laser Corporation) under the conditions of a dispersion pressure of 3 bar and a suction pressure of 90 mbar. The particle size at the point where the distribution curve of volume integration % intersects a horizontal axis of 50% was determined as D50. Note that D10 and D90 were also obtained by the same method.

[SPAN Value]

The particle size distribution spread was determined by the following conversion equation.

$$SPAN = (D90 - D10)/D50$$

[Appearance Evaluation of Color-Spread Object]

<Preparation of Composition for Color Spreading>

A sample powder in an amount of 2.0 parts, 10 parts of a styrene acrylic resin emulsion (manufactured by Seiko PMC Corporation, Hairosu-X, X-436, an aqueous dispersion solution containing 40% by mass of a resin), 0.6 part of an aqueous sodium hexametaphosphate solution (manufactured by FUJIFILM Wako Pure Chemical Corporation, a 5% by mass aqueous solution), and 0.5 part of a VOC-free silicone-based defoaming agent (manufactured by BYK-Chemie Japan K.K., BYK-028, a 5% by mass aqueous solution) were mixed together with Awatori Rentaro manufactured by Thinky Corporation to obtain an ink composition.

The obtained ink composition was spread on a piece of inkjet paper using a bar coater #20, 10 mm in diameter (manufactured by AS ONE Corporation) and was then dried (at room temperature and under the atmosphere) for 1 hour to obtain a color-spread object.

<Evaluation of Appearance of Colored-Spread Object>

For the obtained color-spread object, visual evaluation was performed in accordance with the following items.

[Criteria for Evaluation of Ink Color-Spread Object]

A (Excellent): The color-spread object is a uniform coating without color unevenness, and there are no streaks due to faulty dispersion.
B (Good): The color-spread object is a uniform coating without color unevenness, but there are a few streaks due to faulty dispersion.
C (Failure): Streaks or color unevenness appear in the color-spread object.

[Metal Elemental Analysis Evaluation]

<Sample Preparation>

The color-spread object obtained above was fixed to an aluminum plate, and gold was coated on the surface of the coating of the color-spread object using a magnetron sputtering apparatus (manufactured by Vacuum Device Inc.) to make a sample for measurement.

<Method for Measuring Sample>

For the sample for measurement, the intensity of energy regions corresponding to the characteristic X-rays of Cr-$K\alpha$ and Cu-$K\alpha$ was measured using a table-top SEM (JCM-7000 manufactured by JEOL Ltd.) while scanning the surface on a straight line of about 1 mm under the condition of an acceleration voltage of 15 kV.

<Metal Elemental Analysis Evaluation>

For the profiles showing the peak intensity of Cr and Cu at each point on the surface of the obtained sample, evaluation was performed in accordance with the following items.

[Criteria for Evaluation of Profiles]

A (Excellent): The peaks of Cr and Cu are not unevenly present, and variations in the peak intensity are small.
B (Good): The peaks of Cr and Cu are partially unevenly present, but variations in the peak intensity are small.
C (Failure): The peaks of Cr and Cu are unevenly present, and variations in the peak intensity are large

[Table 1]

| | | Synthesis | | | | | | | |
|---|---|---|---|---|---|---|---|---|---|
| | | Raw materials | | | | | Amount of flux agent* | Mo/ (Cu+Cr) | Firing condition |
| | | CuO | $Cr_2O_3$ | $MoO_3$ | ZnO | $Na_2Mo_2O_7$ | | | |
| | | Parts | Parts | Parts | Parts | Parts | Parts by mass | Molar ratio | °C |
| | Ex. 1 | 7.95 | 15.2 | 1. 16 | - | - | 5.0 | 0.027 | 950 |
| | Ex. 2 | 7.95 | 15.2 | 2.32 | - | - | 10.0 | 0.054 | 950 |
| | Ex. 3 | 7.95 | 15.2 | - | - | 2.32 | 10.0 | 0.022 | 950 |
| | Ex. 4 | 7.95 | 15.2 | 1. 16 | - | - | 5.0 | 0.027 | 900 |
| | Ex. 5 | 7.95 | 15.2 | 2.32 | - | - | 10.0 | 0.054 | 900 |
| | Ex. 6 | 7.95 | 15.2 | - | - | 2.32 | 10.0 | 0.022 | 900 |
| | Comp. Ex. 1 | 7.95 | 15.2 | - | - | - | - | - | 950 |
| | Comp. Ex. 2 | 4.78 | 15.0 | 0.02 | 0.2 | - | 0.1 | 0.001 | 900 |
| *Total parts by mass of $MoO_3$ or $Na_2Mo_2O_7$ to a total of 100 parts by mass of CuO and $Cr_2O_3$ | | | | | | | | | |

[Table 2]

| | XRD | SEM | Particle size | | | Particle size distribution | Appearance evaluation | Elemental analysis evaluation |
|---|---|---|---|---|---|---|---|---|
| | | | Evaluation | | | | | |
| | | Shape | D10 | D50 | D90 | SPAN | | |
| | | | $\mu$m | $\mu$m | $\mu$m | (D90-D10)/D50 | | |
| Ex. 1 | Spinel structure | Octahedron | 0.68 | 1.52 | 2.84 | 1.42 | A | A |
| Ex. 2 | Spinel structure | Octahedron | 1. 00 | 1. 91 | 3.48 | 1.30 | A | A |
| Ex. 3 | Spinel structure | Octahedron | 1. 61 | 3.76 | 8.14 | 1. 74 | B | B |
| Ex. 4 | Spinel structure | Octahedron | 0.96 | 1.72 | 2.81 | 1. 08 | A | A |
| Ex. 5 | Spinel structure | Octahedron | 0.88 | 1. 67 | 2.84 | 1.17 | A | A |
| Ex. 6 | Spinel structure | Octahedron | 1.50 | 3.96 | 9.26 | 1. 96 | B | B |
| Comp. Ex. 1 | Spinel structure + impurities | Amorphous particle | 1.22 | 3.41 | 8.08 | 2.01 | C | C |
| Comp. Ex. 2 | Spinel structure | Amorphous particle | 0.69 | 1. 67 | 4.49 | 2.28 | C | C |

According to PTL 3, it can be inferred that a commercially available copper-chromium oxide spinel (Black 1G manufactured by Shepherd Color Company) has a SPAN value of greater than 2 as in Comparative Example 1 and Comparative Example 2 based on its written particle size.

Reference Signs List

100    inkjet paper
110    color-spread object
120    SEM scanning direction

**Claims**

1. A copper-chromium oxide spinel with a particle size distribution spread SPAN = (D90 - D10)/D50 of 2 or less where, in volume-converted particle size distribution obtained by a laser diffraction and scattering method, particle sizes with a cumulative frequency from a smaller particle size side of 10%, 50%, and 90% are defined as D10, D50, and D90, respectively.

2. The copper-chromium oxide spinel according to claim 1, wherein D50 is 5.0 $\mu$m or less.

3. The copper-chromium oxide spinel according to claim 1 or 2, wherein D90 is 10.0 $\mu$m or less.

4. The copper-chromium oxide spinel according to claim 1 or 2, wherein a shape of the copper-chromium oxide spinel is an octahedron.

5. The copper-chromium oxide spinel according to claim 1, further comprising molybdenum.

6. A resin composition comprising:

   the copper-chromium oxide spinel according to claim 1 or 2;
   a thermoplastic resin or a thermosetting resin; and
   an inorganic filler.

7. A resin molded article made by molding the resin composition according to claim 6.

[FIG. 1]

[FIG. 2]

[FIG. 3]

[FIG. 4]

[FIG. 5]

[FIG. 6]

[FIG. 7]

[FIG. 8]

[FIG. 9]

[FIG. 10]

[FIG. 11]

[FIG. 12]

[FIG. 13]

[FIG. 14]

[FIG. 15]

[FIG. 16]

[FIG. 17]

## INTERNATIONAL SEARCH REPORT

| International application No. |
|---|
| **PCT/JP2023/019459** |

**A.    CLASSIFICATION OF SUBJECT MATTER**

 *C01G 37/00*(2006.01)i; *C08L 101/00*(2006.01)i; *C08K 3/013*(2018.01)i; *C08K 3/24*(2006.01)i; *H05K 3/10*(2006.01)i
 FI:   C01G37/00; C08L101/00; C08K3/013; C08K3/24; H05K3/10 C

According to International Patent Classification (IPC) or to both national classification and IPC

**B.    FIELDS SEARCHED**

Minimum documentation searched (classification system followed by classification symbols)

 C01G25/00-47/00;49/10-99/00 ; C08K3/00-13/08;C08L1/00-101/14; H05K3/10

Documentation searched other than minimum documentation to the extent that such documents are included in the fields searched

 Published examined utility model applications of Japan 1922-1996
 Published unexamined utility model applications of Japan 1971-2023
 Registered utility model specifications of Japan 1996-2023
 Published registered utility model applications of Japan 1994-2023

Electronic data base consulted during the international search (name of data base and, where practicable, search terms used)

 JSTPlus/JMEDPlus/JST7580 (JDreamIII); JSTChina (JDreamIII)

**C.    DOCUMENTS CONSIDERED TO BE RELEVANT**

| Category* | Citation of document, with indication, where appropriate, of the relevant passages | Relevant to claim No. |
|---|---|---|
| Y | JP 2015-501868 A (MITSUBISHI CHEMICAL EUROPE GMBH) 19 January 2015 (2015-01-19)<br>    abstract, claims, paragraphs [0001]-[0024], [0045]-[0056] | 1-7 |
| Y | JP 2018-188342 A (DIC CORPORATION) 29 November 2018 (2018-11-29)<br>    claims, paragraphs [0002], [0005], [0007]-[0026], [0033]-[0041], [0047], [0059]-[0060] | 1-7 |
| Y | WO 2017/221372 A1 (DIC CORPORATION) 28 December 2017 (2017-12-28)<br>    claims, paragraphs [0002], [0005], [0010]-[0024], [0029]-[0032], [0039]-[0044], [0056]-[0058] | 1-7 |
| Y | WO 2018/207679 A1 (DIC CORPORATION) 15 November 2018 (2018-11-15)<br>    claims, paragraphs [0002]-[0004], [0008]-[0054] | 1-7 |
| A | WO 2018/003481 A1 (DIC CORPORATION) 04 January 2018 (2018-01-04)<br>    entire text | 1-7 |
| A | JP 8-281109 A (TOKIN CORP) 29 October 1996 (1996-10-29)<br>    entire text | 1-7 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 July 2023** | **01 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

| International application No. |
| --- |
| **PCT/JP2023/019459** |

| Patent document cited in search report | | | Publication date (day/month/year) | Patent family member(s) | Publication date (day/month/year) |
| --- | --- | --- | --- | --- | --- |
| JP | 2015-501868 | A | 19 January 2015 | EP 002604648 A1 claims, examples, table 2 CN 103998503 A | |
| JP | 2018-188342 | A | 29 November 2018 | (Family: none) | |
| WO | 2017/221372 | A1 | 28 December 2017 | US 2020-0308014 A1 claims, paragraphs [0002], [0005], [0010]-[0024], [0029]-[0032], [0039]-[0044], [0056]-[0058] EP 003476805 A1 claims, paragraphs [0002], [0005], [0010]-[0024], [0029]-[0032], [0039]-[0044], [0056]-[0058] CN 109415220 A KR 10-2019-0020664 A | |
| WO | 2018/207679 | A1 | 15 November 2018 | US 2020-0062607 A1 claims, paragraphs [0002]-[0004], [0008]-[0054] | |
| WO | 2018/003481 | A1 | 04 January 2018 | US 2020-0180971 A1 entire text CN 2020-0180971 A | |
| JP | 8-281109 | A | 29 October 1996 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004534408 W
- WO 2017199639 A
- JP 2015501868 W